# EUROPEAN PATENT APPLICATION

(11) **EP 3 703 143 A1**
(43) Date of publication of application: **02.09.2020**
(21) Application number: 18870047.0
(22) Date of filing: 24.04.2018
(51) Int. Cl.: H01L 49/00, H01L 49/02

(54) **POWER STORAGE DEVICE**

(30) Priority: 27.10.2017 JP 2017207751
(71) Applicant: Kabushiki Kaisha Nihon Micronics, Musashino-shi Tokyo 1808508 (JP)
(72) Inventor: KUDOH, Takuo, Tokyo 1808505 (JP); TSUNOKUNI, Kazuyuki, Tokyo 1808505 (JP)
(74) Representative: GIE Innovation Competence Group
(86) International application number: PCT/JP2018/016690
(87) International publication number: WO 2019/082421

(57) **Abstract**

An object of the present invention is to provide a power storage device structure in which the number of layers to be laminated is reduced as compared with a conventional power storage device. A power storage device according to the present invention includes a conductive electrode, an insulator and an n-type metal oxide semiconductor, and a charging layer for storing charges and an iridium oxide layer formed of iridium oxide as a material to be used for a dielectric layer of a solid-state electrochromic element are sequentially laminated. Since iridium oxide has a low resistivity, the iridium oxide layer is given the function of the conductive electrode to eliminate the conductive electrode and reduce the number of layers to be laminated.

## Description

### Technical Field

The present invention relates to a power storage device having a simple structure in which a functional layer is integrated with an electrode.

### Background Art

Secondary batteries that are power storage devices include secondary batteries and electrochemical capacitors that store electricity as electrochemical energy by using an oxidation-reduction reaction, capacitors that can store as a change in capacity of an electric double layer. Further, as the secondary battery is known not only an aqueous secondary battery such as a nickel hydride secondary battery, but also a non-aqueous secondary battery such as a lithium ion secondary battery using an active material which is effective for an ion insertion reaction.

Lithium ion secondary batteries are widely used mainly in electronic devices such as portable devices. This is because the lithium ion secondary batteries have a high voltage, have a large charging and discharging capacity, etc.

However, in recent years, polymer batteries that use gel type electrolytes instead of electrolytic solutions and thin-film solid-state secondary batteries that use solid-state electrolytes have been developed so that portable devices, etc. can be configured to be thinner and smaller and further for safety.

Patent Literatures 1 and 2 disclose all-solid secondary batteries using metal oxide semiconductors.

Patent Literature 3 describes a thin-film solid-state secondary battery element in which a first electrode, an electron transport layer, a charging layer, an electron block layer, and a second electrode are sequentially laminated above a substrate. The charging layer contains an inorganic material. The electron transport layer is made of an inorganic oxide material, and the inorganic material oxide contains niobium oxide or tungsten oxide.

Patent Literature 4 discloses a power storage element having a structure in which a conductive first electrode, a power storage layer (charging layer) containing an insulating material and n-type semiconductor particles, a leak suppression layer, a p-type semiconductor layer, and a second electrode are sequentially laminated.

### Citation List

### Patent Literature

Patent Literature 1: International Patent Publication No. WO2012/046325
Patent Literature 2: International Patent Publication No. WO2013/065093
Patent Literature 3: Japanese Unexamined Patent Application Publication No. 2014-154505
Patent Literature 4: Japanese Unexamined Patent Application Publication No. 2016-82125

### Summary of Invention

### Technical Problem

Power storage devices configured by laminating a plurality of functional layers have configurations described in Patent Literatures 1 to 4, for example. As the number of layers to be laminated increases, the number of manufacturing steps also increases according to the number of layers to be laminated, which causes an increase in cost. Therefore, it has been desired to reduce the number of layers to be laminated.

The present invention has an object to provide a power storage device structure in which the number of layers to be laminated is reduced as compared with a conventional power storage device.

### Solution to Problem

In order to solve the above problem, a power storage device according to the present invention includes a conductive electrode, an insulator and an n-type metal oxide semiconductor, and has a structure in which a charging layer for storing charges, and an electrode layer formed of a material of an electrochromic element are sequentially laminated.

Here, iridium oxide is desirable for the electrode layer to be formed from the material of the electrochromic element. A resistance adjusting material may be added to the electrode layer formed of iridium oxide to reduce the resistance. The resistance adjusting material is at least one of metal elements of magnesium, aluminum, tungsten, cobalt and nickel. Further, fluorine may be doped as a resistance adjusting material. The iridium oxide layer whose resistance has been reduced by the resistance adjusting material preferably has a resistivity of 2x10⁻⁵ Ωm or less and a thickness of 200 nm or more.

According to a first aspect of the power storage device of the present invention, a negative conductive electrode, a charging layer including an insulator and an n-type metal oxide semiconductor, and an iridium oxide layer formed of iridium oxide are sequentially laminated. Further, the electrode layer is configured by an iridium oxide layer formed of iridium oxide.

According to a second aspect of the power storage device of the present invention, negative conductive electrode, an electron transport layer, a charging layer including an insulator and an n-type metal oxide semiconductor, and an iridium oxide layer formed of iridium oxide are sequentially laminated. In contrast with the first embodiment, the electron transport layer is added between the negative conductive electrode and the charging layer to increase the efficiency of transporting the electrons stored in the charging layer.

According to third aspect of the power storage device of the present invention, a negative conductive electrode, a charging layer including an insulator and an n-type metal oxide semiconductor, a leak suppression layer, and an iridium oxide layer formed of iridium oxide are sequentially laminated. In contrast with the first aspect, the leak suppression layer is added between the charging layer and the iridium oxide layer formed of iridium oxide to suppress leakage of electrons stored in the charging layer, whereby a voltage holding time after power storage can be increased.

According to a fourth aspect of the power storage device of the present invention, a negative conductive electrode, an electron transport layer, a charging layer including an insulator and an n-type metal oxide semiconductor, a leak suppression layer, and iridium oxide layer formed of iridium oxide are sequentially laminated. In contrast with the first aspect, the electron transport layer is added between the negative conductive electrode and the charging layer, and further, the leak suppression layer is added between the charging layer and the iridium oxide layer formed of iridium oxide. Therefore, the efficiency of transporting electrons to a negative electrode side is increased, and leakage of electrons stored in the charging layer to a positive electrode side is suppressed.

According to a fifth aspect of the power storage device of the present invention, a negative conductive electrode, an electron transport layer that transports electrons, a first charging layer that includes an insulator and a first n-type metal oxide semiconductor, and stores charges, a second charging layer that includes the insulator and a second n-type metal oxide semiconductor which is a material different from the first charging layer, and an iridium oxide layer formed of iridium oxide are sequentially laminated.

In contrast with the third aspect, the fifth aspect is configured so that the charging layer is doubled. In the third embodiment, even if the thickness of the charging layer is increased in order to increase the charging capacity, the charging capacity does not necessarily increase with the increase of the thickness. Therefore, the material of the n-type metal oxide semiconductor is changed to form the second charging layer, and the charging capacity is increased.

In the power storage devices according to the first to fourth aspects of the present invention and the first charging layer and the second charging layer according to the fifth aspect, the insulator is composed of at least one of silicon dioxide, aluminum oxide, and magnesium oxide. The n-type metal oxide semiconductor is composed of at least one of titanium oxide, tin oxide, and zinc oxide.

In the fifth aspect, the n-type metal oxide semiconductor of the first charging layer is composed of at least one of titanium oxide, tin oxide, and zinc oxide. The n-type metal oxide semiconductor of the second charging layer is also composed of at least one of titanium oxide, tin oxide and zinc oxide, but is made of a material different from the n-type metal oxide semiconductor used for the first charging layer.

In the power storage devices according to the second, fourth and fifth aspects of the present invention, the electron transport layer includes at least one of niobium oxide, tungsten oxide, titanium oxide, tin oxide or titanium oxide.

In the power storage devices according to the third and fourth aspects of the present invention, the leak suppression layer is composed of at least one of silicon oxide, silicon nitride, magnesium oxide, and aluminum oxide.

In the first to fifth aspects according to the above-described embodiments, the lamination order may be reversed. In this case, an iridium oxide layer formed of iridium oxide is formed above an insulative substrate (insulating substrate). This is because the iridium oxide layer formed of iridium oxide may be easily formed in some cases.

With respect to the first aspect, the iridium oxide layer formed of iridium oxide, the charging layer including the insulator and the n-type metal oxide semiconductor, and the negative conductive electrode are sequentially laminated above the insulating substrate.

With respect to the second aspect, the iridium oxide layer formed of iridium oxide, the charging layer including the insulator and the n-type metal oxide semiconductor, the electron transport layer, and the negative conductive electrode are sequentially laminated above the insulating substrate.

With respect to the third aspect, the iridium oxide layer formed of iridium oxide, the leak suppression layer, the charging layer including the insulator and the n-type metal oxide semiconductor, and the negative conductive electrode are sequentially laminated above the insulating substrate.

With respect to the fourth aspect, the iridium oxide layer formed of iridium oxide, the leak suppression layer, the charging layer including the insulator and the n-type metal oxide semiconductor, and the electron transport layer, and the negative conductive electrode are sequentially laminated above the insulating substrate.

With respect to the fifth aspect, the iridium oxide layer formed of iridium oxide, the second charging layer including the insulator and the second n-type metal oxide semiconductor, the first charging layer including the insulator and the first n-type metal oxide semiconductor, the electron transport layer, and the negative conductive electrode are sequentially laminated above the insulating substrate.

### Advantageous Effect of Invention

According to the present invention, it is possible to provide a power storage device structure in which the number of layers to be laminated is reduced as compared with a conventional power storage device.

### Brief Description of the Drawings

Fig. 1 is a schematic cross-sectional structural view of a power storage device according to a first embodiment of the present invention;
Fig. 2 is a schematic structural view showing a conventional power storage device;
Fig. 3 is a schematic cross-sectional structural view of a conventional power storage device according to a second embodiment and a power storage device according to the present invention;
Fig. 4 is a schematic cross-sectional structural view of a conventional power storage device according to a third embodiment and a power storage device according to the present invention;
Fig. 5 is a schematic cross-sectional structural view of a conventional power storage device according to a fourth embodiment and a power storage device according to the present invention;
Fig. 6 is a schematic cross-sectional structural view of a conventional power storage device according to a fifth embodiment and a power storage device according to the present invention;
Fig. 7 is a schematic cross-sectional structural view of a power storage device when the lamination order of the first embodiment is reversed;
Fig. 8 is a flowchart showing a method of manufacturing a power storage device according to the fifth embodiment of the present invention;
Fig. 9 is a charge/discharge characteristic measurement system for measuring charge/discharge characteristics of the power storage device; and
Fig. 10 is a diagram showing charge/discharge characteristics of the conventional power storage device in the fourth embodiment of the present invention and the power storage device according to the present invention.

### Description of Embodiments

Next, embodiments will be described with reference to the drawings. In the drawings described below, the same or similar portions are denoted by the same or similar reference signs. However, the drawings are schematic. Therefore, specific thicknesses and dimensions should be determined in consideration of the following description. In addition, it is needless to say that the drawings include portions having different dimensional relationships and ratios among them.

The embodiments described below exemplify devices and methods for embodying the technical idea, but do not specify the material, shape, structure, arrangement, and the like of each component.

The power storage device targeted by the present invention is a power storage device in which a p-type metal oxide semiconductor is laminated on a conductive positive electrode. The p-type metal oxide semiconductor layer has, for example, a function of blocking and suppressing electron leakage from the charging layer. The power storage devices disclosed in Patent Literatures 1 to 4 are cited as conventional power storage devices having this function.

These power storage devices are configured so that a structure in which a charging layer for storing charges and a plurality of functional layers for improving the performance of the power storage device are laminated is sandwiched between positive and negative conductive electrodes. From the viewpoint of simplification of the manufacturing process and cost, it is effective means to reduce the number of layers to be laminated.

Therefore, attention has been paid to nickel oxide (NiO) in a p-type oxide semiconductor layer, and the following examination has been performed.

Nickel oxide (NiO) has properties as a p-type semiconductor, and is also used for electrochromic elements. The electrochromic element has a structure in which an electrochromic material layer and a dielectric layer are laminated between a positive electrode and a negative electrode.

In this solid-state electrochromic element, a DC voltage is applied between the positive electrode and the negative electrode to develop color with an oxidation-reduction reaction. At this time, there is a problem that a leakage current that does not directly contribute to color development flows. In Japanese Unexamined Patent Application Publication No. S55-88028, a current blocking layer is provided between the dielectric layer and the solid-state electrochromic material layer in order to prevent the leakage current.

In the power storage device targeted by the present invention, the charging layer is composed of titanium oxide (TiO₂) and silicon dioxide (SiO₂) as an insulating material, and the charging ability is improved by a manufacturing method using an ultraviolet treatment.

Nickel oxide (NiO) is used for the dielectric layer in the solid-state electrochromic element having the electron blocking layer. It is considerable that materials usable for the dielectric layer of the solid-state electrochromic element including the electron blocking layer can be applied to the power storage device targeted by the present invention.

Therefore, attention has been paid to the material used for the dielectric layer of the solid-state electrochromic element, and a low-resistance material has been studied. Specifically, in the power storage device targeted by the present invention, nickel oxide is used for a p-type metal oxide semiconductor layer in contact with an electrode, and the possibility that the p-type metal oxide semiconductor layer and the positive electrode can be integrated with each other has been investigated by searching a low-resistance material from materials used for the dielectric layer in the solid-state electrochromic element.

Therefore, attention has been paid to iridium oxide (Ir₂O₃) having a low resistance from the materials used for the dielectric layer of the solid-state electrochromic element. Iridium oxide (Ir₂O₃) is also used as a counter electrode of an electrochromic element because it is insoluble and chemically stable and has a coloring property. The dielectric layer of the solid-state electrochromic element may be regarded as an electrode layer. The resistivity is 49x10⁻⁸Ωm. For this reason, if iridium oxide (Ir₂O₃) is used as a p-type metal oxide semiconductor, a power storage device having an integrated simple configuration which is provided with a function of an electrode can be realized.

Generally, the resistance of the electrode is low, and in the case of a metal electrode, for example, the resistivity of silver is 1.59x10⁻⁸Ωm, the resistivity of copper is 1.68x10⁻⁸Ωm, and the resistivity of aluminum is 2.82x10⁻⁸Ωm. The resistivity of ITO (Indium Tin Oxide), which is widely known as a transparent electrode, is about 1.5x10⁻⁶Ωm.

It is difficult to form a film of iridium oxide with a low resistance, and the resistivity greatly depends on a manufacturing condition. Above all, strict condition control is required to mass-produce low-resistance iridium oxide films, which causes increase of the cost. Therefore, it is practically sufficient if the resistivity level of ITO can be realized. For example, the level was 5.05x10⁻⁶Ωm on a trial basis in consideration of a production condition under mass production that enables stable production.

Even in the production condition under mass production, a resistance adjusting material may be added in order to further reduce the resistivity of iridium oxide (Ir₂O₃). The resistance adjusting material includes metal elements such as magnesium (Mg), aluminum (Al), tungsten (W), cobalt (Co), and nickel (Ni). The metal has good conductivity, and the resistivity of magnesium is 4.42x10⁻⁸Ωm, the resistivity of aluminum is 2.82x10⁻⁸Ωm, the resistivity of tungsten is 5.29x10⁻⁸Ωm, and the resistivity of cobalt is 5.81x10⁻⁸Ωm, and the resistivity of nickel is 6.99x10⁻⁸Ωm, so that the metal can be used as a resistance adjusting material for lowering the resistance.

Furthermore, in order to lower the resistivity of iridium oxide (Ir₂O₃), fluorine (F) atoms may be doped. The fluorine (F) atom is a kind of halogen element, belongs to Group 17 and has seven outermost shell electrons. Since oxygen is an element of Group 16, it has six outermost shell electrons. Therefore, the number of electrons to be received by fluorine (F) is smaller, and when oxygen of iridium oxide (Ir₂O₃) is replaced by fluorine (F), the number of electrons increases as a whole, so that the carrier density increases. Therefore, by doping fluorine into iridium oxide (Ir₂O₃), the resistivity can be lowered.

The resistivity of iridium oxide (Ir₂O₃) can be lowered to 2x10⁻⁵Ωm or less by adding a metal element as a resistance adjusting material and further doping fluorine (F). Therefore, iridium oxide (Ir₂O₃) can be treated as a material having both a p-type metal oxide semiconductor and an electrode. Note that the dielectric layer made of iridium oxide is simply referred to as an iridium oxide layer below.

Next, a structure of a power storage device to which iridium oxide (Ir₂O₃) can be applied and an embodiment to which the structure of the power storage device is applied will be described.

### <First Embodiment>

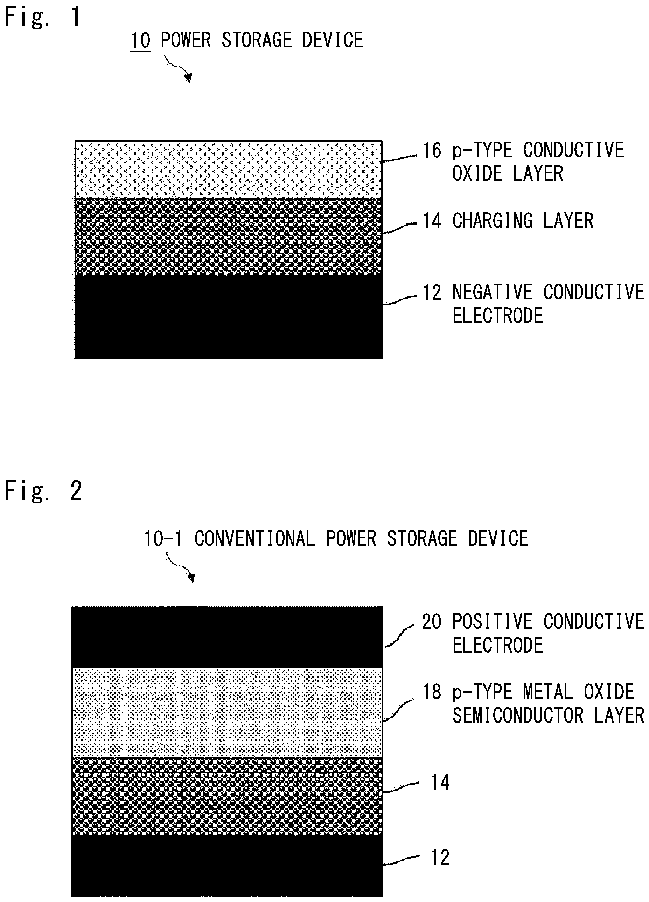

Fig. 1 shows a schematic cross-sectional structure showing a power storage device 10 according to the present invention. The power storage device 10 has a structure in which a negative conductive electrode 12, a charging layer 14 for storing charges, and an iridium oxide layer 16 are sequentially laminated.

The power storage device 10 may be manufactured by sequentially laminating the negative conductive electrode 12, the charging layer 14, and the iridium oxide layer 16 on an insulating substrate. For example, a glass substrate or a resin sheet of a polymer film can be used as the insulating substrate.

The material of the negative conductive electrode 12 includes, for example, a silver (Ag) alloy containing aluminum (Al). Examples of a method of forming the negative conductive electrode 12 include a vapor deposition method such as sputtering, ion plating, electron beam deposition, vacuum deposition, or chemical vapor deposition. Further, the negative conductive electrode 12 may be formed by an electrolytic plating method, an electroless plating method, or the like. As a metal used for plating is generally usable copper (Cu), copper alloy, nickel (Ni), aluminum (Al), silver (Ag), gold (Au), zinc (Zn), tin (Sn), or the like.

When the substrate is a conductive metal foil sheet, for example, a copper foil sheet, an aluminum foil sheet or a stainless steel sheet, the substrate can be used as the negative conductive electrode 12.

The charging layer 14 is a layer formed from an insulating material and an n-type metal oxide semiconductor. The insulating material is, for example, silicon dioxide (SiO₂) or a silicone oil having a siloxane bond. For example, titanium oxide (TiO₂), tin oxide (SnO₂), or zinc oxide (ZnO) is preferable as the n-type metal oxide semiconductor. Further, the n-type metal oxide semiconductor may be a material obtained by combining any two elements of (TiO₂), tin oxide (SnO₂), or zinc oxide (ZnO), or a material obtained by combining three elements of them.

The specific structure of the charging layer 14 may be formed by a layered structure of an insulating material and an n-type metal oxide semiconductor, a structure in which the periphery of a particulate n-type metal oxide semiconductor is covered with an insulating material, or a structure in which a particulate n-type metal oxide semiconductor is buried and mixed in an insulating material.

Titanium oxide (TiO₂) is particularly desirable for the n-type metal oxide semiconductor in order to perform modification based on a photoexcited structural change (photoinduced phase transition) by ultraviolet irradiation.

The n-type metal oxide semiconductor used for the charging layer 14 is generated by decomposition from a metal aliphatic acid salt in a manufacturing process. For this reason, as the metal aliphatic acid salt are used those which can be decomposed or burned to be converted into metal oxides by irradiating ultraviolet rays under an oxidizing atmosphere or baking. As the aliphatic acid are usable, for example, an aliphatic monocarboxylic acid or an aliphatic polycarboxylic acid such as an aliphatic dicarboxylic acid, an aliphatic tricarboxylic acid, or an aliphatic tetracarboxylic acid.

More specifically, examples of saturated aliphatic monocarboxylic acid include formic acid, acetic acid, propionic acid, caproic acid, enanthic acid, caprylic acid, pelargonic acid, capric acid, and stearic acid. As unsaturated aliphatic monocarboxylic acid are usable highly unsaturated monocarboxylic acids such as acrylic acid, butenoic acid, crotonic acid, isocrotonic acid, linolenic acid, and oleic acid.

Since aliphatic acid salts are easily decomposed or burned by heating, have high solvent solubility, form dense films after being decomposed or burned, are easy to handle and low in price, and easily synthesize salts with metals, salts of aliphatic acids and metals are preferable.

Insulating resin as well as inorganic insulating material is usable as the insulating material, and may include thermoplastic resin such as polyethylene, polypropylene, polystyrene, polybutadiene, polyvinyl chloride, polymethyl methacrylate, polyamide, polycarbonate, polyimide or cellulose acetate, or thermosetting resin such as phenol resin, amino resin, unsaturated polyester resin, allyl resin, alkyd resin, epoxy resin or polyurethane.

A method of forming the charging layer 14 is performed by spin coating. First, for example, a solution is prepared by stirring fatty acid titanium and silicone oil together with a solvent. This solution is coated onto the negative conductive electrode 12 using a spin coating device. The number of revolutions is, for example, about 500 to 3000 rpm. After the coating, it is dried on a hot plate. The drying temperature on the hot plate is, for example, about 30°C to 200°C, and the drying time is, for example, about 5 minutes to 30 minutes. Baking is performed after the drying. The baking is performed by using a baking furnace. The baking temperature is, for example, about 300°C to 600°C, and the baking time is, for example, about 10 minutes to 60 minutes.

As a result, the aliphatic acid salt is decomposed to form a fine particle layer of titanium oxide (TiO₂) covered with the insulating film of silicone oil. The above manufacturing method is called a coating thermal decomposition method.

Specifically, the fine particle layer has a structure in which a metal salt of titanium oxide (TiO₂) is embedded in a silicone oil layer. After baking, UV (ultraviolet) irradiation using a low-pressure mercury lamp is performed. An UV irradiation time is, for example, about 10 minutes to 100 minutes. The UV irradiation may be an excimer lamp.

By this baking step and UV irradiation, the silicone oil is turned into an insulating film of silicon dioxide (SiO₂). In addition, the UV irradiation promotes a photoexcited structural change of titanium oxide (TiO₂) to form an energy level for trapping electrons.

Next, a method of forming the iridium oxide layer 16 will be described.

The iridium oxide layer 16 is formed by depositing iridium oxide (Ir₂O₃) on the charging layer 14 by a reactive sputtering method, an electron beam heating deposition method, an MOCVD method, or the like. A method called AIROF (Anodic IRidium Oxide Film) is known as a method of forming a thin film while oxidizing metal iridium. The AIROF method is a method of anodizing metal iridium in a sulfuric acid solution to form an iridium oxide film.

Usually, the iridium oxide film deposited by these deposition methods has an amorphous structure containing microcrystals, and a defect may be present at a grain boundary of the microcrystals. In this case, the electric resistance of iridium oxide may be caused to increase.

Therefore, there is considered a method of mixing iridium oxide (Ir₂O₃) with tin oxide (SnO₂) to form an iridium oxide layer, thereby reducing the electric resistance of the iridium oxide layer. This is because tin oxide (SnO₂) has high conductivity, is chemically stable, and has a lattice constant close to that of iridium oxide (Ir₂O₃).

Although tin oxide has the characteristics of an n-type semiconductor, the proportion of tin oxide to be mixed with iridium oxide (Ir₂O₃) is 20 wt% or less, and thus even when tin oxide (SnO₂) is mixed with iridium oxide (Ir₂O₃), the mixture does not become an n-type semiconductor.

In order to compare the power storage device of the present invention with a conventional storage device, Fig. 2 shows a schematic cross-sectional structure of the conventional power storage device. A conventional power storage device 10-1 shown in Fig. 2 has a structure in which a negative conductive electrode 12, a charging layer 14 for storing charges, a p-type metal oxide semiconductor layer 18, and a positive conductive electrode 20 are sequentially laminated.

The negative conductive electrode 12 is formed by using, for example, a silver alloy containing aluminum or the like and by a vapor phase film forming method such as sputtering, ion plating, electron beam deposition, vacuum deposition, or chemical vapor deposition.

The charging layer 14 is a layer formed from an insulating material and an n-type metal oxide semiconductor. The insulating material is, for example, silicon oxide (SiO₂) or a silicone oil having a siloxane bond. For example, titanium oxide (TiO₂), tin oxide (SnO₂), or zinc oxide (ZnO) is used as n-type metal oxide semiconductor. The n-type metal oxide semiconductor may be a material obtained by combining any two elements of titanium oxide (TiO₂), tin oxide (SnO₂), and zinc oxide (ZnO), or a material obtained by combining three of these elements.

A method of forming the charging layer 14 first prepares a solution in which fatty acid titanium and a silicone oil are stirred together with a solvent, and coats the solution onto the negative conductive electrode 12 by a spin coating method. The number of revolutions is, for example, about 500 to 3000 rpm. After the coating, drying is performed at a temperature of about 30°C to 200°C for a drying time of about 5 minutes to 30 minutes. After the drying, baking is performed by using a baking furnace at a temperature of about 300°C to 600°C for a baking time of about 10 minutes to 60 minutes.

The p-type metal oxide semiconductor layer 18 formed on the charging layer 14 is provided to prevent electrons from leaking to the positive conductive electrode 20 on an upper side. The formation of the p-type metal oxide semiconductor layer is performed by forming a p-type metal oxide semiconductor film by a sputter deposition method or the like. Specific materials of the p-type metal oxide semiconductor layer 18 are nickel oxide (NiO), copper aluminum oxide (CuAlO₂), and the like. The materials are not limited to the metal oxides, and may be various kinds of p-type organic semiconductor materials and inorganic semiconductor materials.

Known metal, metal oxide, or organic conductive material may be used as a material of the positive conductive electrode 20. The material is not particularly limited as long as it is a conductive material.

Examples of the material of the positive conductive electrode 20 include indium tin oxide (ITO), fluorine-doped tin oxide (FTO), antimony-doped tin oxide (ATO), indium zinc oxide, niobium titanium oxide, carbon nanotube, graphene or the like, and metals such as aluminum, silver (Ag), gold (Au), platinum (Pt), titanium (Ti), and chromium (Cr). These materials may be used alone, or may be used in the form of a layer in which a plurality of materials are laminated.

Examples of a method of forming the positive conductive electrode 20 include known vacuum film forming methods such as sputtering and vapor deposition, and film forming methods using various printing methods. In these processes, it is possible to perform patterning with a shadow mask or the like.

As described above, the conventional power storage device 10-1 has the lamination structure of the negative conductive electrode 12, the charging layer 14, the p-type metal oxide semiconductor layer 18, and the positive conductive electrode 20. The p-type metal oxide semiconductor layer shares in a blocking function of blocking the leakage of electrons stored in the charging layer, and the positive conductive electrode 20 shares in a conductive electrode function, and respective manufacturing steps for forming these layers have been required.

The subject matter of the present invention is to reduce the number of layers to be laminated in the power storage devices and, accordingly, to reduce the number of manufacturing steps. The two-layer structure of the p-type metal oxide semiconductor layer 18 and the positive conductive electrode 20 is integrated into a one-layer structure of only one iridium oxide layer 16. The power storage device according to the present invention shown in Fig. 1 can reduce the number of layers to be laminated and thus reduce the number of manufacturing steps accordingly as compared with the conventional power storage device shown in Fig. 2.

The present invention can be applied to not only the conventional power storage device structure shown in Fig. 2, but also other conventionally disclosed power storage device structures, which will be described below.

### <Second Embodiment>

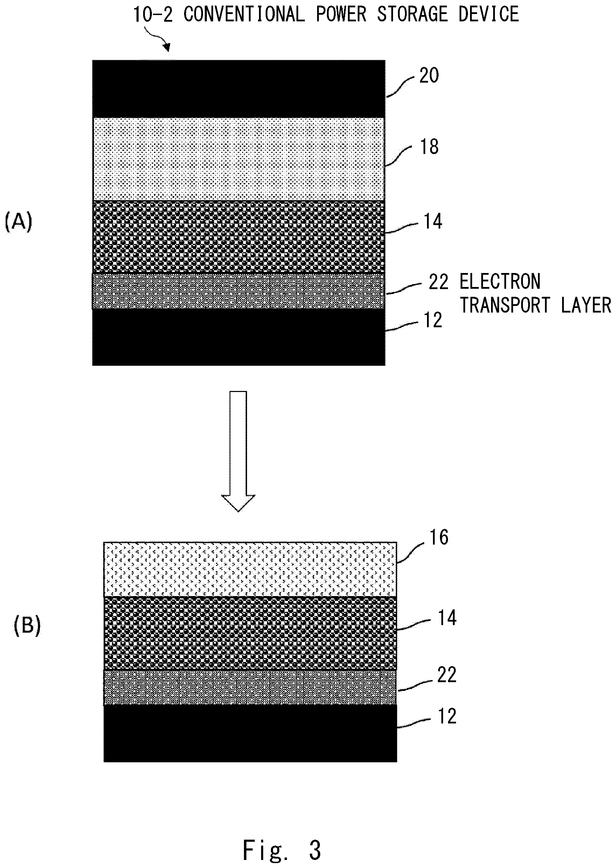

Fig. 3 shows schematic cross-sectional structures of a conventional power storage device 10-2 targeted by the present invention (see Patent literature 3 and the like) and a power storage device according to the present invention. Fig. 3(A) shows a conventional power storage device structure, which is a lamination structure in which an electron transport layer 22 is added between the negative conductive electrode 12 and the charging layer 14 in contrast with the conventional power storage device 10-1 shown in Fig. 2.

In the second embodiment, the electron transport layer 22 added to the conventional power storage device 10-1 is provided to transport electrons. The material used for the electron transport layer has an electron transport property, and is selected in consideration of compatibility with the charging layer material and resistance to the manufacturing process of the charging layer. For example, an inorganic oxide material is suitable, and titanium oxide (TiO₂), zinc oxide (ZnO) and the like which are n-type metal oxide semiconductors are suitable. Further, an oxide containing any one or both of niobium oxide and tungsten oxide may be used. Further, a composite oxide material containing another oxide in niobium oxide or tungsten oxide may be used.

A method of forming the electron transport layer 22 performs film formation, for example by a sputtering method using, as a target, titanium oxide (TiO₂), or titanium oxide containing any one or both of niobium oxide and tungsten oxide.

Fig. 3(B) shows a schematic cross-sectional structure of the power storage device according to the present invention. In this structure, the p-type metal oxide semiconductor layer 18 and the positive conductive electrode 20 are configured to be integrated by the iridium oxide layer 16 to reduce the number of layers to be laminated as compared with the conventional power storage device 10-2.

### <Third Embodiment>

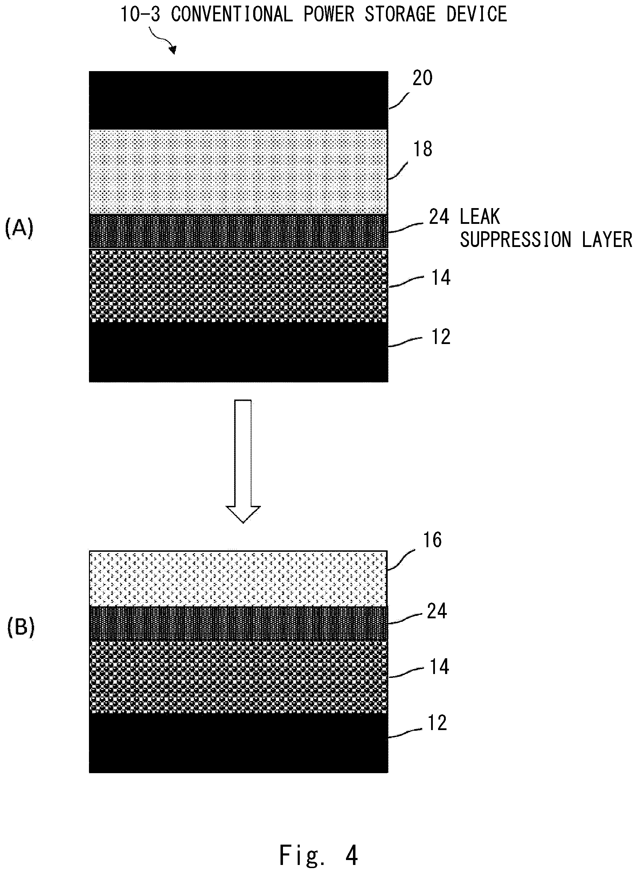

Fig. 4 shows schematic cross-sectional structures of a conventional power storage device 10-3 targeted by the present invention (see Patent Literature 4 and the like) and a power storage device according to the present invention. Fig. 4(A) shows a conventional power storage device structure, which is a structure in which a leak suppression layer 24 is laminated between the charging layer 14 for storing charges and the p-type metal oxide semiconductor layer 18 in contrast with the conventional power storage device 10-1 shown in Fig. 2.

The leak suppression layer 24 is arranged between the charging layer 14 and the p-type metal oxide semiconductor layer 18 for the purpose of suppressing leakage of electrons or holes by spacing the charging layer 14 from the p-type metal oxide semiconductor layer 18. It is desirable that the energy of the lower end of the conduction band of the material forming the leak suppression layer 24 is higher than the energy of the lower end of the conduction band of the n-type metal oxide semiconductor in the charging layer 14, and the energy of the upper end of the valence band of that is lower than the energy of the upper end of the valence band of the p-type metal oxide semiconductor forming the p-type metal oxide semiconductor layer 18. By satisfying these relationships, an effect of suppressing leakage can be obtained.

The material forming the leak suppression layer 24 is typically an insulating material. Examples of such an insulating material include an inorganic insulating material and insulating resin. Those listed as the insulating materials forming the charging layer 14 can be used as the above materials. Typically, the material is at least one selected from the group consisting of silicon dioxide (SiO₂), magnesium oxide (MgO), and aluminum oxide (Al₂O₃). When the leak suppression layer 24 is made of an insulating material different from the insulating material forming the charging layer 14, the effect of further suppressing the leakage can be obtained. The leak suppression layer 24 using these materials can be easily formed by an existing film forming method such as the sputtering method.

Fig. 4(B) shows a schematic cross-sectional structure of a power storage device according to the present invention. In this structure, the p-type metal oxide semiconductor layer 18 and the positive conductive electrode 20 are integrated by the iridium oxide layer 16 to reduce the number of layers to be laminated as compared with the conventional power storage device 10-3.

### <Fourth Embodiment>

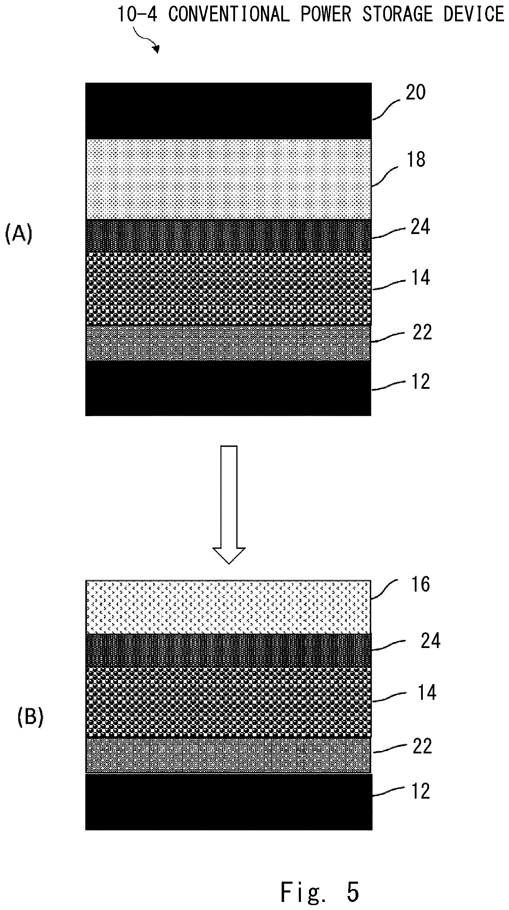

Fig. 5 shows schematic cross-sectional structures of a conventional power storage device 10-4 targeted by the present invention (see Patent Literatures 2 to 4 and the like) and a power storage device according to the present invention. Fig. 5(A) shows a structure of the conventional power storage device 10-4, which is a structure in which the electron transport layer 22 is laminated between the negative conductive electrode 12 and the charging layer 14 for storing charges, and the leak suppression layer 24 is laminated between the charging layer 14 for storing charges and the p-type metal oxide semiconductor layer 18 in contrast with the conventional power storage device 10-1 shown in Fig. 2.

The electron transport layer 22 and the leak suppression layer 24 are formed by using the materials and manufacturing methods described in the second and third embodiments.

Fig. 5(B) shows a schematic cross-sectional structure of the power storage device according to the present invention. In this structure, the p-type metal oxide semiconductor layer 18 and the positive conductive electrode 20 are integrated by the iridium oxide layer 16 to reduce the number of layers to be laminated as compared with the conventional power storage device 10-4.

### <Fifth Embodiment>

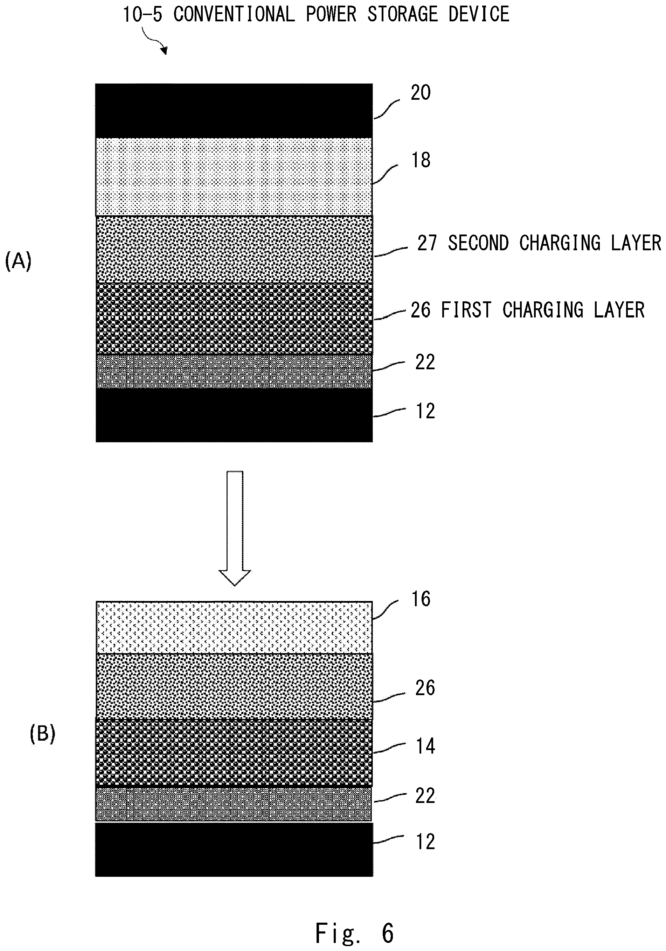

Fig. 6 shows schematic cross-sectional structures of a conventional power storage device 10-5 targeted by the present invention and a power storage device according to the present invention. Fig. 6(A) shows a conventional power storage device structure, which is a structure in which the first charging layer 26 and the second charging layer 27 are laminated with the charging layer 14 of the conventional power storage device 10-2 being configured by two layers.

The first charging layer 26 and the second charging layer of the conventional power storage device 10-5 are layers each formed of an insulating material and an n-type metal oxide semiconductor, and the n-type metal oxide semiconductors of the first charging layer 26 and the second charging layer 27 are formed of different materials from each other. The insulating material is, for example, silicon dioxide (SiO₂). For example, titanium oxide (TiO₂), tin oxide (SnO₂), or zinc oxide (ZnO) is used for the n-type metal oxide semiconductors. The n-type metal oxide semiconductors are formed of a material obtained by combining any two elements of titanium oxide (TiO₂), tin oxide (SnO₂), and zinc oxide (ZnO), but the first charging layer 26 and the second charging layer are formed of different materials from each other.

When the first charging layer 26 is composed of, for example, titanium oxide (TiO₂) and silicon dioxide (SiO₂), a solution in which fatty acid titanium and silicone oil are stirred together with a solvent is first prepared, and the solution is coated on the negative conductive electrode 12 by the spin coating method. The number of revolutions is, for example, about 500 to 3000 rpm. After the coating, drying is performed at a temperature of about 30°C to 200°C for a drying time of about 5 minutes to 30 minutes. After the drying, baking is performed by using a baking furnace at a temperature of about 300°C to 600°C for a baking time of about 10 minutes to 60 minutes. After the baking, UV irradiation using a low-pressure mercury lamp is performed. The UV irradiation time is, for example, about 10 minutes to 100 minutes.

When the second charging layer is composed of, for example, tin oxide (SnO₂) and silicon dioxide (SiO₂), a solution in which fatty acid tin and silicone oil are stirred together with a solvent is first prepared, and the solution is coated onto the negative conductive electrode 12 by the spin coating method. This solution is coated onto the first charging layer 26 by using a spin coating device. The number of revolutions is, for example, about 500 to 3000 rpm. After the coating, drying is performed at a temperature of about 30°C to 200°C for a drying time of about 5 minutes to 30 minutes. After the drying, baking is performed by using a baking furnace at a temperature of about 300°C to 600°C for a baking time of about 10 minutes to 60 minutes. After the baking, UV irradiation using a low-pressure mercury lamp is performed. The UV irradiation time is, for example, about 10 minutes to 100 minutes.

The reason why the second charging layer is formed by using an n-type metal oxide semiconductor different from that of the first charging layer is to increase the charging capacity. According to experimental results, in the case of increasing the thickness of the first charging layer, there was a tendency for the charging capacity not to increase, but rather to decrease when the thickness increased to a certain thickness or more. For this reason, when the second charging layer which was different from the first charging layer in the material of the n-type metal oxide was laminated on the first charging layer, a result indicating that the charging capacity was increased was obtained. From this result, the charging layer is configured to include two layers whose n-type metal oxide materials are different from each other.

Fig. 6(B) shows a schematic cross-sectional structure of the power storage device according to the present invention. In the structure, the p-type metal oxide semiconductor layer 18 and the positive conductive electrode 20 are integrated by the iridium oxide layer 16 to reduce the number of layers to be laminated as compared with the conventional power storage device 10-5.

### <Sixth Embodiment>

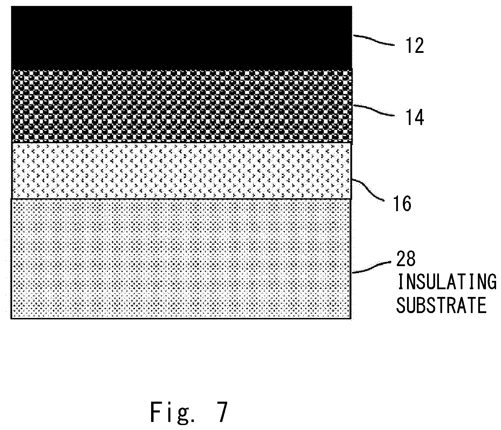

Fig. 7 shows a structure in which the lamination order of the power storage device 10 of Fig. 1 is reversed so that the iridium oxide layer 16, the charging layer 14 and the negative conductive electrode 12 are sequentially formed on the insulating substrate 28. This is one method of first forming the iridium oxide layer 16 to produce a stable power storage device. This is because there are various methods for forming the iridium oxide layer 16, but some of these methods may affect the functional layers such as the charging layer 14 that have been formed already.

For example, with respect to a method of forming a thin film of iridium oxide, when the thin film is formed by a method called AIROF (Anodic IRidium Oxide Film) for anodizing metal iridium in a sulfuric acid solution to form an iridium oxide film, it is necessary to immerse a sample in the sulfuric acid solution, which may cause other functional layers to be dissolved. Furthermore, even when an iridium oxide film is formed by a sputtering method, a condition such as a film formation temperature may affect other functional layers. In such a case, it is therefore necessary to first form a thin film of iridium oxide (Ir₂O₃) on the substrate. A stable power storage device can be manufactured by first forming an iridium oxide film on an insulating substrate having solution-resisting and heat-resisting properties.

The structure having a reversed lamination order is not limited to the structure shown in Fig. 7, and may be applied to power storage devices having other configurations. For example, with respect to the power storage device described in the second embodiment, the iridium oxide layer 16, the charging layer 14, the electron transport layer 22, and the negative conductive electrode 12 are sequentially laminated on the insulating substrate 28. With respect to the power storage device described in the third embodiment, the iridium oxide layer 16, the leak suppression layer 24, the charging layer 14, and the negative conductive electrode 12 are sequentially laminated above an insulating substrate 28.

With respect to the power storage device described in the fourth embodiment, the iridium oxide layer 16, the leak suppression layer 24, the charging layer 14 for storing charges, the electron transport layer 22, and the negative conductive electrode 12 are sequentially laminated on the insulating substrate 28. With respect to the power storage device described in the fifth embodiment, the iridium oxide layer 16, the second charging layer 27, the first charging layer 26, the electron transport layer 22, and the negative conductive electrode 12 are sequentially laminated.

As described above, the present invention is applicable to various types of power storage devices that have been conventionally disclosed.

### (Examples)

The power storage device according to the present invention was actually manufactured, and characteristics thereof were evaluated to confirm the effects of the present invention. First, the manufactured power storage device is the power storage device shown in Fig. 6(B), and a manufacturing method will be described below.

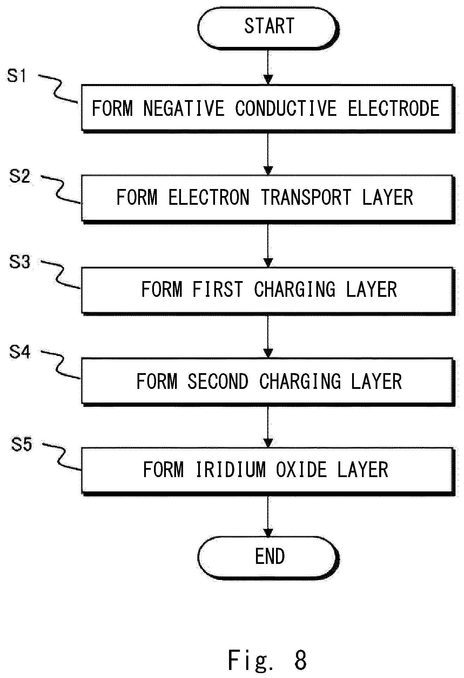

Fig. 8 shows a flow of manufacturing the power storage device according to the present invention. The power storage device to be manufactured used, as the substrate, glass which was an insulating material, and was manufactured by the process of manufacturing steps S1 to S5.

In step S1, a washed glass substrate was prepared, and a negative conductive electrode was formed so as to have a film thickness of 100 to 300 nm by a sputter deposition method using chromium as a target. An RF sputtering apparatus was used as the manufacturing apparatus.

In step S2, a titanium oxide film having an anatase type crystal structure which is an n-type metal oxide semiconductor was formed as an electron transport layer to be laminated on the negative conductive electrode by the sputter deposition method. The film thickness of the electron transport layer was 50 nm to 200 nm.

In step S3, the first charging layer was formed. A method of forming the first charging layer first coated a mixed solution of fatty acid titanium as a precursor of titanium oxide and silicone oil onto the formed electron transport layer. The coating was performed by the spin coating method, and the mixed liquid was dropped onto the glass substrate on which the negative conductive electrode and the electron transport layer were laminated while rotating the glass substrate at, for example, about 500 to 3000 rpm, thereby forming a coating film having a thickness of about 0.3 to 2 µm.

After the coating, drying was performed on a hot plate. The drying temperature on the hot plate is, for example, about 50°C to 100°C, and the drying time is, for example, about 5 minutes to 30 minutes. Furthermore, baking was performed after the drying. The baking after the drying was performed in the atmosphere by using a baking furnace. The baking temperature was, for example, about 200°C to 400°C, and the baking time was, for example, about 10 minutes to 60 minutes.

After the baking, UV irradiation using a low-pressure mercury lamp was performed. The UV irradiation time was, for example, about 10 minutes to 100 minutes. The low-pressure mercury lamp has a spectrum with strong intensity at wavelengths of 185 nm and 254 nm. Therefore, for example, the bonding energy of the C=C bond is 558.7 KJ/mol, the bonding energy of the OH bond is 457.0 KJ/mol, and the bonding energy of the CH bond is 408.9 KJ/mol. Therefore, a silicon dioxide (SiO₂) insulating film can be formed by cutting the bonds of methyl groups, phenyl groups, etc. of the silicone oil and releasing C and H. At this time, titanium oxide (TiO₂) forms an energy level for accumulating electrons due to a photoexcited structural change (photoinduced phase transition).

The UV irradiation may be performed with an excimer lamp. The low-pressure mercury lamp has a spectrum with strong intensity at wavelengths of 185 nm and 254 nm, but a xenon excimer lamp has a light emission center wavelength at a shorter wavelength of 172 nm, which is a wavelength enough to cut the bonds of methyl groups, phenyl groups, etc. in the silicone oil. Further, the band gap of titanium oxide (anatase type) is 3.2 eV, and light having a wavelength shorter than 387 nm, that is, ultraviolet light is absorbed to excite electrons in a valence band to a conduction band. Therefore, the excimer lamp having a wavelength of 172 nm can also induce the photoexcited structural change.

In step S4, the second charging layer was formed. A method of forming the second charging layer first coated a mixed solution of a fatty acid tin as a precursor of tin oxide (SnO₂) and silicone oil onto the formed first charging layer. The coating was performed by the spin coating method, and the mixed liquid was dropped on the glass substrate on which the negative conductive electrode, the electron transport layer, and the first charging layer were laminated while rotating the glass substrate at, for example, about 500 to 3000 rpm, thereby forming a coating film having a thickness of about 0.3 to 2 µm.

After the coating, drying was performed on a hot plate. The drying temperature on the hot plate is, for example, about 50°C to 100°C, and the drying time is, for example, about 5 minutes to 30 minutes. Furthermore, after the drying, baking was performed. The baking after the drying was performed in the atmosphere by using a baking furnace. The baking temperature is, for example, about 200°C to 400°C, and the baking time is, for example, about 10 minutes to 60 minutes.

After the baking, UV irradiation using a low-pressure mercury lamp was performed. The UV irradiation time is, for example, about 10 minutes to 100 minutes. The low-pressure mercury lamp has strong spectra at wavelengths of 185 nm and 254 nm. Therefore, for example, the bonding energy of the C=C bond is 558.7 KJ/mol, the bonding energy of the OH bond is 457.0 KJ/mol, and the bonding energy of the CH bond is 408.9 KJ/mol. Therefore, a silicon dioxide (SiO₂) insulating film can be formed by cutting the bonds of methyl groups, phenyl groups, etc. of the silicone oil and releasing C and H.

The UV irradiation may be performed by an excimer lamp. The low-pressure mercury lamp has strong spectra at wavelengths of 185 nm and 254 nm. However, a xenon excimer lamp has a light emission center wavelength at a shorter wavelength of 172 nm, which is a wavelength enough to cut the bonds of methyl groups and phenyl groups in silicone oil.

In step S5, an iridium oxide layer according to the present invention was formed by the sputtering method. Iridium metal and sintered targets of iridium oxide (Ir₂O₃) and iridium halide are suitable as a target material for the iridium oxide layer. A plurality of these target materials may be combined and used as a target material.

An inert gas such as He, Ne, Ar, Kr, or Xe is suitable as a material gas for sputtering. Further, with respect to a source gas for causing a gas phase reaction during sputtering, oxygen (O₂) is particularly suitable as a source gas for introducing oxygen, and nitrogen dioxide (NO₂), carbon dioxide (CO₂), and the like may be used. These gases may also have a function for sputtering.

Conditions for forming the iridium oxide layer by the sputtering method include temperature, pressure, and the like. First, it is preferable that the temperature of the substrate on which the iridium oxide layer is formed is 300°C or less. The oxygen content in the iridium oxide layer can be controlled by the substrate temperature. When it is desired to increase the oxygen content, it is better to set the substrate temperature to a relatively low temperature, and when it is desired to reduce the oxygen content in the iridium oxide layer, it is better to set the substrate temperature to a relatively high temperature.

The internal pressure under sputtering is 1x10⁻⁴ to 1 Torr, and a wide range from DC to high frequency can be used as the frequency of a power source for sputtering.

The film thickness of the formed iridium oxide layer is 500 to 1000 nm, preferably 200 to 1000 nm. When the film thickness is 1000 nm or more, productivity is poor and defects may occur. The film thickness of the iridium oxide film of the power storage device whose characteristics were measured were set to two thicknesses of 200 nm and 400 nm.

### (Comparative Examples)

In order to confirm the effect of the present invention, a power storage device having a conventional structure was produced for comparison. The conventional power storage device structure is a power storage device having a structure shown in Fig. 6(A).

The conventional power storage device was manufactured by executing a step of forming a p-type metal oxide semiconductor layer above the second charging layer and a step of forming a positive conductive electrode above the p-type metal oxide semiconductor instead of the step S5 of forming the iridium oxide layer in the manufacturing flow shown in Fig. 8.

With respect to the p-type metal oxide semiconductor layer, a nickel oxide film was formed by the sputter deposition method. The film thickness of the nickel oxide film as the p-type metal oxide semiconductor layer is, for example, 100 to 1000 nm. Note that a method of forming the p-type metal oxide semiconductor layer is not limited to the sputtering method, and thin film forming methods such as a deposition method, an ion plating method, and an MBE method can be used.

The positive conductive electrode was formed by the sputter deposition method using aluminum as a material, and an aluminum film having a thickness of, for example, 100 to 300 nm was formed.

### (Charging and discharging characteristics)

The effect of the present invention is confirmed by measuring the characteristics of the power storage devices manufactured in the first embodiment and a comparative example. The characteristics to be measured are charging and discharging characteristics.

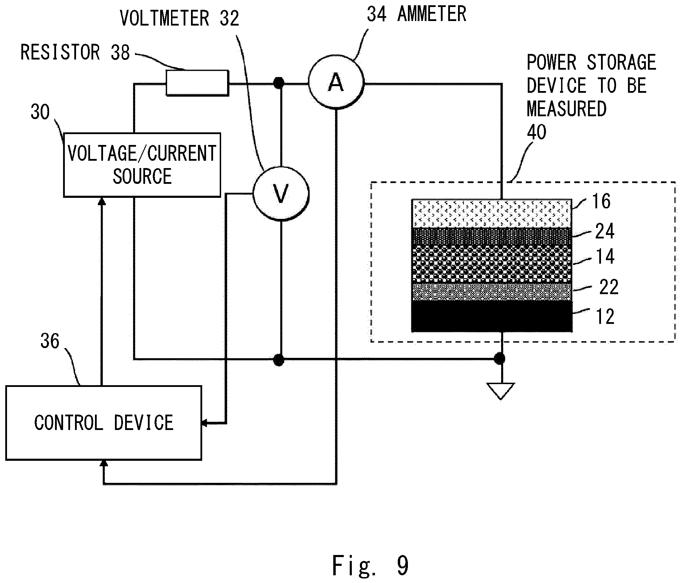

Fig. 9 shows an example of a charging and discharging characteristics measurement system.

The charging and discharging characteristics measurement system includes a voltage/current source 30, a voltmeter 32, an ammeter 34, a control device 36, and a resistor 38. The resistor 38 is connected between the voltage/current source 30 and a power storage device 40 to be measured, and the voltage/current source 30 is connected to the negative conductive electrode 12 and is connected to the iridium oxide layer 16 or the positive conductive electrode 20 of the power storage device 40 to be measured via the resistor 38. The voltmeter 32 and the ammeter 34 are connected between the voltage/current source 30 and the power storage device 40 to be measured. The power storage device 40 to be measured is the manufactured power storage device.

The control device 36 is connected to the voltage/current source 30, the voltmeter 32, and the ammeter 34. The control device 36 controls a charging process for earthing the negative conductive electrode 12 and applying a positive voltage to the iridium oxide layer 16 or the positive conductive electrode 20, and a discharging process for measuring a discharging characteristic from the iridium oxide layer 16 or the positive conductive electrode 20, and acquires voltage and current data.

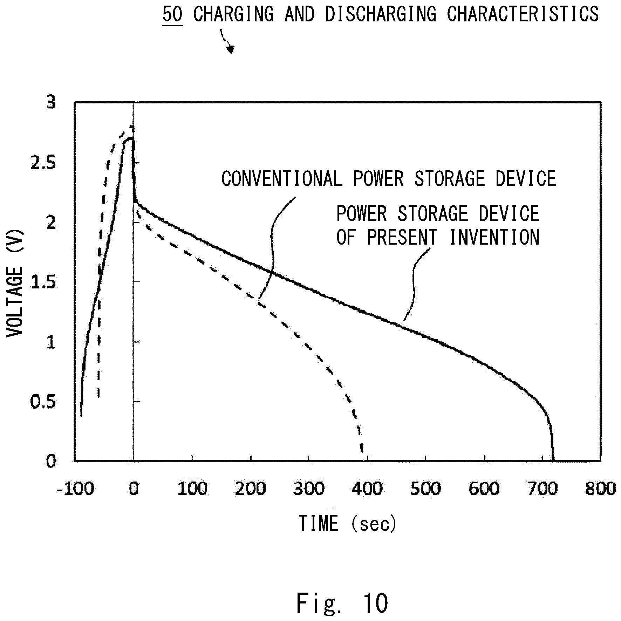

Fig. 10 shows the charging and discharging characteristics 50 of the power storage device of the present invention (the film thickness of the iridium oxide layer is 400 nm) manufactured in the first embodiment, and the conventional power storage device manufactured in the comparative example. The horizontal axis represents the measurement time, which is set to zero at a discharging start time, and set to a minus value under charging. The power storage device was charged at a constant current. The vertical axis represents the voltage.

In each case, the characteristics as a power storage device were obtained. The power storage device of the present invention had a discharging end time of 720 seconds which was longer as compared with the conventional power storage device having a discharging end time of about 390 seconds. From this result, it was confirmed that sufficient performance was achieved even when the p-type metal oxide semiconductor layer and the positive conductive electrode 20 of the conventional power storage device were replaced by the iridium oxide layer.

### (Other embodiments)

The present invention can be applied to various other power storage devices disclosed in related arts.

For example, applicable power storage devices are the power storage device in Fig. 1 (hereinafter, power storage device A), the power storage device in Fig. 3(B) (hereinafter, power storage device B), the power storage device in Fig 4(B) (hereinafter referred to as power storage device C), and the power storage device of Fig. 5(B) (hereinafter referred to as power storage device D).

The power storage device A was manufactured by steps S1, S3, and S5 in the manufacturing flow for the power storage device shown in Fig. 8. The power storage device B can be manufactured by steps S1, S2, S3, and S5 in the manufacturing flow for the power storage device shown in Fig. 8.

With respect to the power storage device C, the leak suppression layer is formed after steps S1 and S3 in the manufacturing flow for the power storage device shown in Fig. 8. The leak suppression layer made of an insulating material is formed. The leak suppression layer is formed by forming a thin film of silicon oxide by the sputter deposition method using silicon as a target. The insulation resistance value of the leak suppression layer can be controlled by the thickness of the leak suppression layer, and the thickness is 10 to 100 nm. Thereafter, the p-type conductive oxide layer is formed in step S5 of the manufacturing flow for the power storage device shown in Fig. 8.

In the manufacturing flow of the power storage device shown in Fig. 8, the power storage device D is formed by forming the electron transport layer after step S1, forming the leak suppression layer after step S3, and further forming at step S5.

Although there are differences in the charging and discharging characteristics and the charging capacity from the power storage device of the present invention shown in Fig. 10, the manufactured power storage devices A to D have substantially the same results as the power storage device of the present invention shown in Fig. 10, and thus the p-type metal oxide semiconductor layer and the positive conductive electrode can be replaced by the iridium oxide layer.

The power storage device of the present invention is characterized in that the lamination structure of the p-type metal oxide semiconductor layer and the conductive electrode on the positive electrode side is configured by the iridium oxide layer. Iridium oxide used has higher resistance than the metal electrode. However, since transparency is not required, it can be easily conceived by a person skilled in the art that the resistance can be sufficiently reduced by doping of fluorine or addition of a metal element, and the charging and discharging characteristics can be improved.

Several embodiments have been described above, but it should be understood that the discussion and drawings forming a part of the disclosure are illustrative and should not be construed as limiting. From this disclosure, various alternative embodiments, examples, and operation techniques will be apparent to those skilled in the art.

As described above, the present embodiments include various embodiments which are not described herein.

### Reference Signs List

- 10: power storage device
- 10-1, 10-2, 10-3, 10-4, 10-5: conventional power storage device
- 12: negative conductive electrode
- 14: charging layer
- 16: iridium oxide layer
- 18: p-type metal oxide semiconductor layer
- 20: positive conductive electrode
- 22: electron transport layer
- 24: leak suppression layer
- 26: first charging layer
- 27: second charging layer
- 28: insulating substrate
- 30: voltage/current source
- 32: voltmeter
- 34: ammeter
- 36: control device
- 38: resistor
- 40: power storage device to be measured
- 50: charging and discharging characteristics

## Claims

1. A power storage device comprising:
a conductive electrode;
a charging layer that includes an insulator and an n-type metal oxide semiconductor and is configured to store charges; and
an electrode layer formed of a material to be used in an electrochromic element, the conductive electrode, the charging layer and the electrode layer being sequentially laminated.

2. The power storage device according to claim 1, wherein a material used in the electrochromic device is iridium oxide.

3. The power storage device according to claim 2, wherein a resistance adjusting material is added to the electrode layer formed of iridium oxide.

4. The power storage device according to claim 3, wherein the resistance adjusting material is at least one metal element of magnesium, aluminum, tungsten, cobalt and nickel.

5. The power storage device according to claim 3, wherein the resistance adjusting material is fluorine.

6. The power storage device according to any one of claim 3 or 5, wherein the electrode layer formed of iridium oxide has a resistivity of 2x10⁻⁵ Ωm or less.

7. The power storage device according to claim 2, wherein the electrode layer has a thickness of 200 nm or more.

8. A power storage device comprising:
a conductive electrode;
an electron transport layer configured to transport electrons;
a charging layer that includes an insulator and an n-type metal oxide semiconductor and is configured to store charges; and
an iridium oxide layer formed from iridium oxide, the conductive electrode, the electron transport layer, the charging layer and the iridium oxide layer being sequentially laminated.

9. A power storage device comprising:
a negative conductive electrode;
a charging layer that includes an insulator and an n-type metal oxide semiconductor and is configured to store charges;
a leak suppression layer configured to suppress leakage of electrons; and
an iridium oxide layer formed of iridium oxide, the negative conductive electrode, the charging layer, the leak suppression layer and the iridium oxide layer being sequentially laminated.

10. A power storage device comprising:
a negative conductive electrode;
an electron transport layer configured to transport electrons;
a charging layer that includes an insulator and an n-type metal oxide semiconductor and is configured to store charges;
a leak suppression layer configured to suppress leakage of electrons; and
an iridium oxide layer formed of iridium oxide, the negative conductive electrode, the electron transport layer, the charging layer, the leak suppression layer and the iridium oxide layer being sequentially laminated.

11. A power storage device comprising:
a negative conductive electrode;
an electron transport layer configured to transport electrons;
a first charging layer that includes an insulator and a first n-type metal oxide semiconductor and is configured to store charges;
a second charging layer including the insulator and a second n-type metal oxide semiconductor that is a material different from that of the first charging layer; and
an iridium oxide layer formed of iridium oxide, the negative conductive electrode, the electron transport layer, the first charging layer, the second charging layer and the iridium oxide layer being sequentially laminated.

12. The power storage device according to any one of claims 8 to 10, wherein the insulator used in the charging layer is composed of at least one of silicon dioxide, aluminum oxide, and magnesium oxide.

13. The power storage device according to claim 11, wherein the first n-type metal oxide semiconductor used in the first charging layer is at least one of titanium oxide, tin oxide, and zinc oxide.

14. The power storage device according to claim 11, wherein the second n-type metal oxide semiconductor used in the second charging layer is at least one of titanium oxide, tin oxide, and zinc oxide, and is a material different from that of the first n-type metal oxide semiconductor.

15. The power storage device according to any one of claims 8, 10 or 11, wherein the electron transport layer includes at least one of niobium oxide, tungsten oxide, tin oxide, or titanium oxide.

16. The power storage device according to any one of claim 9 or 10, wherein the leak suppression layer is composed of at least one of silicon oxide, silicon nitride, magnesium oxide and aluminum oxide.
